# EUROPÄISCHE PATENTSCHRIFT

(11) **EP 2 294 642 B1**
(45) Veröffentlichungstag und Bekanntmachung des Hinweises auf die Patenterteilung: **23.09.2015**
(21) Anmeldenummer: 09771996.7
(22) Anmeldetag: 17.06.2009
(51) Int. Cl.: H01L 51/56

(54) **VERFAHREN ZUR HERSTELLUNG EINES ORGANISCHEN ELEKTRONISCHEN BAUELEMENTS**
METHOD FOR PRODUCING AN ORGANIC ELECTRONIC COMPONENT
PROCÉDÉ DE FABRICATION D'UN COMPOSANT ÉLECTRONIQUE ORGANIQUE

(30) Priorität: 03.07.2008 DE 102008031533
(43) Veröffentlichungstag der Anmeldung: 16.03.2011
(73) Patentinhaber: OSRAM OLED GmbH, 93049 Regensburg (DE)
(72) Erfinder: PHILIPPENS, Marc, 93049 Regensburg (DE); SCHEICHER, Richard, 86444 Affing-Anwalting (DE); LOVICH, Andreas, 86169 Augsburg (DE); FISCHER, Ansgar, 86343 Königsbrunn (DE); MUELLER, Martin, 86836 Untermeitingen (DE); HEUSER, Karsten, 91056 Erlangen (DE); PAETZOLD, Ralph, 91154 Roth (DE)
(74) Vertreter: Epping - Hermann - Fischer
(86) Internationale Anmeldenummer: PCT/DE2009/000860
(87) Internationale Veröffentlichungsnummer: WO 2010/000226

(56) Entgegenhaltungen:
- EP-A- 1 575 085
- US-A1- 2005 184 662
- US-A1- 2006 226 523
- US-A1- 2006 275 950
- US-A1- 2007 091 062
- US-A1- 2007 096 208

## Beschreibung

Es werden ein Verfahren zur Herstellung eines organischen elektronischen Bauelements und ein organisches elektronisches Bauelement angegeben.

Bis heute gibt es weltweit kein Herstellungsverfahren für großflächige organische Leuchtdioden (OLEDs) für Beleuchtungszwecke, das eine im Vergleich zu Displays kostenäquivalente hohe Produktionsrate erzielt. Bekannte Herstellungsverfahren greifen auf Kenntnisse und Techniken zurück, die aus der Herstellung von LCD- oder OLED-Displays stammen und die für die Herstellung großflächiger OLEDs angepasst und optimiert wurden. Dabei beruht die Herstellung großflächiger OLEDs in bekannten Verfahren beispielsweise noch auf der Bereitstellung von einzelnen, großflächigen Glassubstraten mit einer Indium-Zinn-Oxid-Beschichtung, auf die in großvolumigen, abgeschlossenen Beschichtungsanlagen ("in-line evaporators") organische Schichten, die kleine organische Moleküle aufweisen, und Metallelektroden abgeschieden werden. Diese Technik ist jedoch technisch aufwändig zu handhaben und muss hinsichtlich vieler Aspekte verbessert werden, um eine wirtschaftliche und kostengünstige Herstellung von großflächigen OLEDs zu ermöglichen. Einer der wesentlichen Kostenfaktoren dabei ist die Handhabung der Glassubstrate sowie der Masken, die zur Ausbildung von aktiven Bereichen auf den Substraten benötigt werden.

Bisher ist jedoch kein Verfahren bekannt, dass zur Herstellung von großflächigen Beleuchtungseinrichtungen mit OLEDs effizienter ist und das sich hinsichtlich der Anforderungen dergestalt von denen für die Herstellung von OLED-Displays unterscheidet, dass die Herstellungskosten derart reduziert werden können und OLED-Beleuchtungseinrichtungen wirtschaftlich und damit konkurrenzfähig im Vergleich zu anderen Beleuchtungseinrichtungen werden. Insbesondere kann dies auch auf Projektgeschäfte zutreffen, in denen eine hohe Flexibilität der Produktion wegen vieler verschiedener organischer elektronischer Produkten mit kleinen Stückzahlen von großer Bedeutung sein kann.

Die Druckschrift US 2006/275950 A1 beschreibt ein Verfahren zur Herstellung eines flexiblen Displays, bei dem auf einen starren Glasträger ein flexibles Kunststoffsubstrat aufgeklebt wird, auf das eine organische Dünnfilmstruktur mit organischen TFTs oder organischen LEDs aufgebracht wird. Darüber wird ein weiterer Träger mit einem weiteren flexiblen Substrat mit einer weiteren Dünnfilmstruktur aufgebracht und die starren Träger werden wieder entfernt.

US 2006/0226523 beschreibt die Herstellung von OLEDs auf einem flexiblen Substrat mittels einer Bandbeschichtungsanlage.

Eine Aufgabe zumindest einer Ausführungsform ist es, ein Verfahren zur Herstellung eines organischen elektronischen Bauelements anzugeben, das einen funktionellen Schichtenstapel aufweist.

Diese Aufgabe wird durch ein Verfahren mit den Merkmalen des unabhängigen Patentanspruchs gelöst. Weitere Merkmale und vorteilhafte Ausführungen und Ausgestaltungen des Verfahrens sind in den abhängigen Ansprüchen gekennzeichnet und gehen weiterhin aus der nachfolgenden Beschreibung und den Figuren hervor.

Ein Verfahren zur Herstellung eines organischen elektronischen Bauelements umfasst insbesondere die Teilschritte:
A) Herstellen zumindest eines funktionellen Schichtenstapels mit den Teilschritten:
   A1) Bereitstellen eines flexiblen ersten Substrats,
   A2) Großflächiges Aufbringen zumindest einer organischen Schicht auf dem ersten Substrat mittels einer Bandbeschichtungsanlage und
   A3) Vereinzeln des ersten Substrats mit der zumindest einen organischen Schicht in eine Mehrzahl funktioneller Schichtenstapel,
B) Bereitstellen eines zweiten Substrats, das eine geringere Flexibilität und eine höhere Dichtigkeit gegenüber Feuchtigkeit und Sauerstoff als das erste Substrat aufweist, und
C) Aufbringen des zumindest einen der Mehrzahl der funktionellen Schichtenstapel mit einer der organischen Schicht abgewandten Oberfläche des ersten Substrats auf dem zweiten Substrat.

Dass eine Schicht oder ein Element "auf" oder "über" einer anderen Schicht oder einem anderen Element angeordnet oder aufgebracht ist, kann dabei hier und im Folgenden bedeuten, dass die eine Schicht oder das eine Element unmittelbar in direktem mechanischen und/oder elektrischen Kontakt auf der anderen Schicht oder dem anderen Element angeordnet ist. Weiterhin kann es auch bedeuten, dass die eine Schicht oder das eine Element mittelbar auf beziehungsweise über der anderen Schicht oder dem anderen Element angeordnet ist. Dabei können dann weitere Schichten und/oder Elemente zwischen der einen und der anderen Schicht beziehungsweise zwischen dem einen und dem anderen Element angeordnet sein.

Dass eine Schicht oder ein Element "zwischen" zwei anderen Schichten oder Elementen angeordnet ist, kann hier und im Folgenden bedeuten, dass die eine Schicht oder das eine Element unmittelbar in direktem mechanischen und/oder elektrischen Kontakt oder in mittelbarem Kontakt zur einen der zwei anderen Schichten oder Elementen und in direktem mechanischen und/oder elektrischen Kontakt oder in mittelbarem Kontakt zur anderen der zwei anderen Schichten oder Elementen angeordnet ist. Dabei können bei mittelbarem Kontakt dann weitere Schichten und/oder Elemente zwischen der einen und zumindest einer der zwei anderen Schichten beziehungsweise zwischen dem einen und zumindest einem der zwei anderen Element angeordnet sein.

Hier und im Folgenden bezeichnen "unten" und "oben" Anordnungen von Schichten und Elementen des organischen elektronischen Bauelements relativ zum zweiten Substrat und/oder zur zumindest einen organischen Schicht. Eine "untere" Schicht kann dabei zwischen dem zweiten Substrat und einer "oberen" Schicht angeordnet sein, sodass die untere Schicht auf dem zweiten Substrat aufgebracht ist und die obere Schicht auf der dem zweiten Substrat abgewandten Seite der unteren Schicht. Insbesondere kann eine untere Schicht beispielsweise zwischen dem zweiten Substrat und der organischen Schicht angeordnet sein und eine obere Schicht auf der dem zweiten Substrat abgewandten Seite der organischen Schicht.

Hier und im Folgenden kann "flexibel" insbesondere ein Substrat bezeichnen, das nicht starr sondern biegbar, insbesondere reversibel biegbar, ist. Es kann dabei aber insbesondere auch ein Substrat als flexibel bezeichnet sein, das nicht bis zu unendlich kleinen Biegeradien biegbar ist, so dass ein flexibles Substrat im Sinne der vorliegenden Beschreibung beispielsweise auch einen minimalen Biegeradius aufweisen kann, ab dem bei kleineren Biegeradien eine irreversible Verformung des Substrats eintreten würde.

Das Aufbringen der zumindest einen organischen Schicht mittels der Bandbeschichtungsanlage auf dem ersten Substrat in einem Bandbeschichtungsprozess, auch als so genanntes "web-based coating" oder "roll-to-roll coating" bezeichnet, ermöglicht eine Beschichtung des ersten Substrats in einem kostengünstigen und groß skalierbaren Prozess. Derartige Bandbeschichtungsverfahren sind beispielsweise bekannt aus dem Zeitungsdruck oder der Beschichtung von Kartoffelchips-Packungen mit Siliziumoxid.

Materialien, die geeignet sind in Bandbeschichtungsanlagen beschichtet zu werden, müssen typischerweise eine gewisse und geeignete Flexibilität aufweisen. Flexible, für Bandbeschichtungsanlagen geeignete Materialien können jedoch dabei beispielsweise im Falle von Kunststoffmaterialien eine geringe Dichtigkeit gegenüber Feuchtigkeit und Sauerstoff aufweisen. Da das erste Substrat auf das zweite Substrat mit einer höheren Dichtigkeit gegenüber Feuchtigkeit und Sauerstoff aufgebracht wird, kann das erste Substrat hinsichtlich seiner Eigenschaften für den Bandbeschichtungsprozess optimiert werden, ohne dass die Dichtigkeit des ersten Substrats gegenüber Feuchtigkeit und Sauerstoff bei der Auswahl möglicher Materialien und Formen des ersten Substrats berücksichtigt werden muss. Ferner können für Bandbeschichtungsanlagen geeignete Substratmaterialien, beispielsweise dünne Kunststoff- und/oder Metallfolien, eine geringe Stabilität und Robustheit beispielsweise gegen Verbiegungen oder andere Verformungen aufweisen und daher eine nur eingeschränkte Handhabbarkeit ermöglichen. Durch die Kombination des ersten Substrats mit dem zweiten Substrat kann das zweite Substrat auch als Stützsubstrat für das organische elektronische Bauelement dienen.

Somit kann in dem hier beschriebenen Verfahren eine hohe Produktionsrate durch das Aufbringen der zumindest einen organischen Schicht mittels der Bandbeschichtungsanlage und gleichzeitig eine hohe Dichtigkeit gegenüber Sauerstoff und Feuchtigkeit durch die Kombination des ersten mit dem zweiten Substrat ermöglicht werden.

In der Bandbeschichtungsanlage können Schichten mittels nasschemischer oder trockenchemischer Prozesse aufgebracht werden. Dabei können auch nass- und trockenchemische Verfahren, etwa Druckverfahren und Vakuum-basierte Verfahren, kombiniert und/oder in einer kombinierten Abfolge zum Einsatz kommen. Insbesondere können im hier beschriebenen Verfahren Schichten beispielsweise ohne Maskentechnik strukturiert oder unstrukturiert aufgebracht werden. Ein strukturiertes Aufbringen einer Schicht umfassend ein bestimmtes Material kann beispielsweise durch eine zeitliche Variation der aufzubringenden Menge des Materials erreicht werden.

Das hier beschriebene Verfahren ist im verfahrenstechnischen Sinne robust, also wenig fehleranfällig, und weist beispielsweise mit der Aufbringung der zumindest einen organischen Schicht mittels einer Bandbeschichtungsanlage Verfahrensschritte auf, die durch ihre einfache Handhabung eine Erhöhung der Produktionsrate ermöglichen können. Dadurch ermöglicht das hier beschriebene Verfahren eine verfahrenstechnisch elegante und fortgeschrittene Herstellungsmethode, die sowohl hinsichtlich der Verfahrensschritte als auch hinsichtlich der verwendeten Maschinen und Anlagen im Vergleich zu bekannten Verfahren weniger fehleranfällig und wirtschaftlicher ist und die eine skalierbare, schnelle und kosteneffektive beziehungsweise - sparende Prozesskette ermöglicht.

Ein mit dem oben beschriebenen Verfahren hergestelltes Bauelement umfasst
- zumindest einen funktionellen Schichtenstapel mit zumindest einer organischen Schicht auf einem flexiblen ersten Substrat und
- ein zweites Substrat, auf dem der zumindest eine funktionelle Schichtenstapel mit einer der organischen Schicht abgewandten Oberfläche des ersten Substrats angeordnet ist,
   wobei
- das zweite Substrat eine geringere Flexibilität und eine höhere Dichte gegenüber Feuchtigkeit und Sauerstoff als das erste Substrat aufweist.

Das organische elektronische Bauelement kann insbesondere durch das oben beschriebene Verfahren kostengünstig und effizient herstellbar sein.

Die im Folgenden beschriebenen Merkmale können gleichermaßen für das oben beschriebene Verfahren wie auch für das optische elektronische Bauelement gelten.

Das erste Substrat kann beispielsweise als Folie aus einem Kunststoff und/oder einem Metall bereitgestellt werden. Das Metall kann dabei insbesondere Edelstahl, Aluminium und/oder Kupfer aufweisen oder aus einem oder mehreren Metallen sein. Der Kunststoff kann eines oder mehrere Polyolefine wie etwa Polyethylen (PE) hoher und niedriger Dichte und Polypropylen (PP) aufweisen. Weiterhin kann der Kunststoff auch Polyvinylchlorid (PVC), Polystyrol (PS), Polyester und/oder bevorzugt Polycarbonat (PC), Polyethylenterephthalat (PET), Polyethersulfon (PES) und/oder Polyethylennaphthalat (PEN) aufweisen.

Das erste Substrat kann dabei biegbar und aufrollbar sein und insbesondere als auf einer Rolle aufgerolltes Folienband bereitgestellt werden. Das erste Substrat kann dabei auch eine Mischung, eine Schichtenfolge und/oder ein Laminat aus einem oder mehreren Kunststoffen und/oder aus einem oder mehreren Metallen aufweisen. Das erste Substrat kann eine Dicke von kleiner oder gleich 1 mm, bevorzugt kleiner oder gleich 500 µm und besonders bevorzugt kleiner oder gleich 250 µm aufweisen. Weiterhin kann das erste Substrat eine Dicke von größer oder gleich 1 µm aufweisen. Beispielsweise kann das erste Substrat eine Dicke von etwa 5 µm oder eine Dicke von etwa 12 µm aufweisen. Je dicker das erste Substrat ausgeführt ist, desto stabiler ist es hinsichtlich des Aufbringens der zumindest einen organischen Schicht in der Bandbeschichtungsanlage und auch in den folgenden Verfahrensschritten. Je dünner das erste Substrat ist, desto biegbarer und leichter ist das erste Substrat.

Das erste Substrat, insbesondere ein als Folie im obigen Sinne bereitgestelltes erstes Substrat, muss nicht optimiert hinsichtlich seiner Durchlässigkeit bzw. Barrierefunktion für Feuchtigkeit und/oder Sauerstoff sein. "Durchlässig" kann dabei eine derart hohe Permeabilität gegenüber der Diffusion von Feuchtigkeit und/oder Sauerstoff bedeuten, dass die zumindest eine organische Schicht und/oder weitere Schichten oder Elemente durch das erste Substrat für einen dauerhaften Betrieb des organischen elektronischen Bauelements nicht ausreichend vor Feuchtigkeit und/oder Sauerstoff geschützt werden kann.

Beispielsweise kann das erste Substrat als Metallfolie oder als Kunststofffolie oder als Schichtenfolge mit einer Kunststoffolie und einer Metallfolie bereitgestellt werden. Dabei kann die beispielsweise eine Metallfolie die Funktion einer unteren Elektrodenschicht für das im Verfahren herstellbare elektronische Bauelement übernehmen. Weiterhin kann das erste Substrat ein reines Metall oder eine Metalllegierung aufweisen. Darüber hinaus kann das erste Substrat auch mit einer Beschichtung in Form eines isolierenden oder elektrisch leitenden Bragg-Reflektors und/oder mit einer Beschichtung umfassend eine transparente Pufferschicht, etwa einer Kunststoffschicht, bereitgestellt werden. Alternativ oder zusätzlich können derartige Schichten auch mittels der Bandbeschichtungsanlage aufgebracht werden. Die untere Elektrodenschicht kann zwischen dem ersten Substrat und der zumindest einen organischen Schicht angeordnet sein oder durch das erste Substrat gebildet werden. Weiterhin kann das erste Substrat als untere Elektrode ein transparentes leitendes Oxid (transparent conductive oxide, kurz "TCO") wie beispielsweise Zinkoxid, Zinnoxid, Cadmiumoxid, Titanoxid, Indiumoxid oder Indiumzinnoxid (ITO) aufweisen. Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO₃, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein.

Die untere Elektrodenschicht kann weiterhin eines oder mehrere Metalle aufweisen, etwa Aluminium, Barium, Indium, Silber, Gold, Magnesium, Kalzium oder Lithium sowie Verbindungen, Kombinationen und Legierungen davon. Die untere Elektrodenschicht kann auch eine Kombination mit zumindest einer TCO-Schicht und zumindest einer Metallschicht aufweisen.

Insbesondere kann die untere Elektrodenschicht transparent oder reflektierend ausgeführt sein und eines oder mehrere der vorab genannten Materialien aufweisen.

Das erste Substrat kann transparent sein. Dabei kann das erste Substrat als lichtstreuende und/oder als lichtlenkende Folie bereitgestellt werden. Das erste Substrat kann dazu beispielsweise eine Oberflächenstruktur in Form einer Aufrauung und/oder Mikrostrukturen wie etwa Mikroprismen aufweisen. Alternativ oder zusätzlich kann das erste Substrat eine Kunststofffolie aufweisen, die Streupartikel und/oder einen Wellenlängenkonversionsstoff aufweist. Dadurch kann das erste Substrat als Lichtleiter, als Konversionsfolie und/oder als Streufolie ausgebildet sein, die Licht beispielsweise im fertigen organischen elektronischen Bauelement durch das erste Substrat lenken oder leiten kann, von der zumindest einen organischen Schicht erzeugte elektromagnetische Strahlung zumindest teilweise in elektromagnetische Strahlung mit einer anderen Wellenlänge konvertieren kann und/oder beispielsweise die Einkopplung von Licht in das zweite Substrat verbessern kann.

Die Streupartikel können dabei auf der Oberfläche des ersten Substrats beziehungsweise der Kunststofffolie angeordnet sein oder sie können in der als Matrixmaterial ausgeführten Kunststofffolie eingeschlossen sein. Insbesondere können die Streupartikel beispielsweise ein Metalloxid, so etwa Titanoxid oder Aluminiumoxid wie etwa Korund, und/oder Glaspartikel und/oder Kunststoffpartikel, die einen vom Matrixmaterial unterschiedlichen Brechungsindex aufweisen, umfassen. Weiterhin können die Streupartikel Hohlräume aufweisen und beispielsweise in Form von Kunststoffhohlkugeln ausgeführt sein. Die Streupartikel können dabei Durchmesser oder Korngrößen von weniger als einem Mikrometer bis zu einer Größenordnung von 10 Mikrometer oder auch bis zu 100 Mikrometer aufweisen.

Der Wellenlängenkonversionsstoff kann einen oder mehrere anorganische und/oder organische Materialien aufweisen, die beispielsweise ausgewählt sein können aus: Granate der Seltenen Erden und der Erdalkalimetalle, Nitride, Nitridosilikate, Sione, Sialone, Aluminate, Oxide, Halophosphate, Orthosilikate, Sulfide, Vanadate, Chlorosilikate, Perylene, Benzopyrene, Coumarine, Rhodamine und Azo-Farbstoffe.

Das erste Substrat kann dabei im Verfahrensschritt A1 bereits eine Oberflächenstruktur und/oder Streupartikel aufweisend bereitgestellt werden alternativ oder zusätzlich können eine Oberflächenstruktur und/oder Streupartikel vor oder während des Verfahrensschritts A2 auf der der im Verfahrensschritt A2 aufzubringenden organischen Schicht zugewandten, oberen Oberfläche des ersten Substrats oder auf der der im Verfahrensschritt A2 aufzubringenden organischen Schicht abgewandten, unteren Oberfläche des ersten Substrats aufgebracht werden.

Weiterhin kann im Verfahrensschritt A2 vor dem Aufbringen der zumindest einen organischen Schicht eine untere Elektrodenschicht auf dem ersten Substrat aufgebracht werden. Die untere Elektrodenschicht kann dabei eines oder mehrere Metalle aufweisen, etwa Aluminium, Barium, Indium, Silber, Gold, Magnesium, Kalzium oder Lithium sowie Verbindungen, Kombinationen und Legierungen davon. Alternativ oder zusätzlich kann im Verfahrensschritt A2 als untere Elektrodenschicht eine oder mehrere TCO-Schichten aufgebracht werden. Die untere Elektrodenschicht auch eine Kombination mit zumindest einer TCO-Schicht und zumindest einer Metallschicht aufweisen. Die untere Elektrodenschicht kann dabei beispielsweise mittels eines Aufdampfverfahrens oder mittels Sputtern aufgebracht werden. Weiterhin kann auf dem ersten Substrat im Verfahrensschritt A2 vor dem Aufbringen der zumindest einen organischen Schicht eine Metallfolie auflaminiert werden.

Die untere Elektrodenschicht kann zusammenhängend und großflächig auf dem ersten Substrat aufgebracht werden oder angeordnet sein. Alternativ oder zusätzlich kann die zumindest eine organische Schicht im Verfahrensschritt A2 zusammenhängen und großflächig aufgebracht werden. "Zusammenhängend und großflächig" kann in diesem Zusammenhang für eine Schicht bedeuten, dass die Schicht nach dem Aufbringen keine voneinander getrennten und elektrisch voneinander isolierten Teilbereiche aufweist. Weiterhin kann die großflächige und zusammenhängende Schicht eine Hauptoberfläche des ersten Substrats gänzlich bedecken und damit flächendeckend aufgebracht werden beziehungsweise angeordnet sein. Ein derartiges zusammenhängendes und großflächiges Aufbringen der zumindest einen organischen Schicht kann gerade mittels der Bandbeschichtungsanlage effektiv und kostensparend erfolgen.

Die zumindest eine organische Schicht kann im Verfahrensschritt A2 als Teil einer organischen Schichtenfolge aufgebracht werden. Insbesondere kann das organische elektronische Bauelement mit der zumindest einen organischen Schicht und/oder der organischen Schichtenfolge als organische lichtemittierende Diode (OLED) ausgebildet sein. Dazu können die zumindest eine organische Schicht oder die organische Schichtenfolge beispielsweise Elektronentransportschichten, elektrolumineszierende Schichten, und/oder Lochtransportschichten aufweisen oder als solche ausgeführt sein. Die zumindest eine organische Schicht und/oder die organische Schichtenfolge können organische Polymere, organische Oligomere, organische Monomere, organische kleine, nicht-polymere Moleküle ("small molecules") oder Kombinationen daraus aufweisen.

Abhängig vom Material der zumindest einen organischen Schicht kann diese mittels der Bandbeschichtungsanlage beispielsweise durch nasschemische und/oder vakuumbasierte Verfahren wie etwa Aufdampfen, Aussprühen, Aufdrucken oder Aufrakeln auf dem ersten Substrat aufgebracht werden.

Die zumindest eine organische Schicht kann zusammenhängend und großflächig aufgebracht werden. Weiterhin kann die zumindest eine organische Schicht auch lateral strukturiert aufgebracht werden.

Auf der zumindest einen organischen Schicht kann eine obere Elektrodenschicht aufgebracht werden. Die obere Elektrodenschicht kann dabei eine oder mehrere der weiter oben im Zusammenhang mit der unteren Elektrodenschicht genannten Metalle und/oder TCOs aufweisen. Dabei kann die obere Elektrodenschicht nach dem Aufbringen der zumindest einen organischen Schicht im Verfahrensschritt A2 und vor dem Verfahrensschritt A3 zusammenhängend und großflächig aufgebracht werden. Insbesondere können die untere Elektrodenschicht, die zumindest eine organische Schicht und die obere Elektrodenschicht im Verfahrensschritt A2 mittels der Bandbeschichtungsanlage aufgebracht werden.

Alternativ dazu kann die obere Elektrodenschicht auch nach dem Vereinzeln im Verfahrensschritt A3 auf der zumindest einen organischen Schicht zumindest einer der durch das Vereinzeln herstellbaren funktionellen Schichtenstapel aufgebracht werden. Die obere Elektrode kann dabei vor oder alternativ auch nach dem Verfahrensschritt C aufgebracht werden.

Das erste Substrat und die erste Elektrode können transparent ausgeführt sein, so dass beispielsweise ein als OLED ausgeführtes organisches elektronisches Bauelement als so genannte "Bottom-Emitter-OLED" im Betrieb durch die untere Elektrodenschicht und das erste Substrat sowie durch ein transparent ausgeführtes zweites Substrat in der zumindest einen organischen Schicht erzeugtes Licht abstrahlen kann. Alternativ oder zusätzlich kann auch die obere Elektrodenschicht transparent ausgeführt sein, sodass das als OLED ausgeführte organische elektronische Bauelement auch als so genannte "Top-Emitter-OLED" ausgeführt sein kann. Dabei kann das organische elektronische Bauelement gleichzeitig als Bottom- und als Top-Emitter ausgeführt sein, so dass in der organischen Schicht erzeugtes Licht durch das erste und zweite Substrat und durch die obere Elektrodenschicht beidseitig abgestrahlt werden kann. Insbesondere kann eine als Bottom- und Top-Emitter ausgeführte OLED zumindest transparent sein.

Die untere Elektrodenschicht kann beispielsweise als Anode ausgeführt sein und die obere Elektrodenschicht als Kathode. Alternativ dazu können auch die obere Elektrodenschicht als Anode und die untere Elektrodenschicht als Kathode ausgeführt sein.

Das erste Substrat mit der zumindest einen organischen Schicht kann im Verfahrensschritt A3 mittels eines mechanischen, optischen oder thermischen Trennverfahrens oder einer Kombination daraus in eine Mehrzahl funktioneller Schichtenstapel lateral vereinzelt wird. Ein mechanisches Trennverfahren kann beispielsweise mechanisches Schneiden ("cutting") und/oder Stanzen ("die cutting") umfassen. Ein optisches Trennverfahren kann beispielsweise Lasertrennen ("laser cutting") umfassen. Ein thermisches Trennverfahren kann beispielsweise Schmelztrennen mittels eines heißen Drahts ("hot wire cutting") umfassen.

Weiterhin kann das erste Substrat im Verfahrensschritt A1 bereits mit zusammenhängenden Vereinzelungsbereichen, zwischen denen Vereinzelungslinien wie etwa Sollbruch- oder Sollreißlinien und/oder Perforationslinien angeordnet sind, bereitgestellt werden, so dass auf das erste Substrat mit den zusammenhängen Vereinzelungsbereichen im Verfahrensschritt A2 die zumindest eine organische Schicht kontinuierlich aufgebracht werden kann. Im Verfahrensschritt A3 können die Vereinzelungsbereiche mit der zumindest einen organischen Schicht dann entlang der vorgesehenen Vereinzelungslinien einfach aus dem ersten Substrat herausgelöst werden.

Da die Verfahrensschritte A1 und A2 vor dem Vereinzeln im Verfahrensschritt A3 unabhängig von der späteren Form der funktionellen Schichtenstapel sind, kann das erste Substrat mit der zumindest einen organischen Schicht nach dem Verfahrensschritt A2 im Verfahrensschritt A3 in funktionelle Schichtenstapel in jeder beliebigen Form vereinzelt werden. Jeder der Mehrzahl der funktionellen Schichtenstapel umfasst dann nach dem Vereinzeln das erste Substrat und darauf die zumindest eine organische Schicht und - soweit vorhanden - eine untere und/oder einer obere Elektrodenschicht und/oder eine organische Schichtenfolge. Die funktionellen Schichtenstapel können nach dem Vereinzeln dieselbe Form oder jeweils verschieden Formen aufweisen. Dabei kann die Vereinzelung auch im Hinblick auf eine optimale Ausnutzung der Fläche des ersten Substrats mit der zumindest einen organischen Schicht durchgeführt werden, um einen möglichen Ausschuss an Substratfläche des ersten Substrats zu minimieren oder sogar gänzlich zu vermeiden. Durch die Vereinzelung in funktionelle Schichtenstapel kann die Form der späteren aktiven Fläche des organischen elektronischen Bauelements, beispielsweise also die Leuchtfläche bei einem als OLED ausgeführten organischen elektronischen Bauelement, ohne aufwändige Strukturierungs- und Maskenprozesse gewählt und individuell verändert und an geänderte Designs und Layouts angepasst werden.

Das zweite Substrat, das im Verfahrensschritt B bereitgestellt wird, kann bevorzugt hermetisch dicht gegenüber Sauerstoff und/oder Feuchtigkeit sein. Das kann bedeuten, dass das zweite Substrat eine Dicke aufweist, die ausreichend ist, dass kein Sauerstoff und/oder keine Feuchtigkeit durch das zweite Substrat diffundieren können. Weiterhin kann das auch bedeuten, dass das zweite Substrat ein Material aufweist, das generell oder in Verbindung mit einer ausreichenden Dicke
nicht permeabel für Sauerstoff und/oder Feuchtigkeit ist. Das zweite Substrat kann dazu Metall und/oder Glas und/oder Keramik aufweisen. Weiterhin kann das zweite Substrat auch flexibles, dünnes Glas und/oder einen Kunststoff mit hermetisch dichten Barriereschichten, etwa hochdichten Oxid und/oder Nitridschichten, aufweisen.

Das zweite Substrat kann weiterhin auch als UV-Schutz und/oder als Schutz gegenüber mechanischen Beeinträchtigungen ausgeführt sein. Weiterhin kann das zweite Substrat auch als Stützsubstrat für das organische elektronische Bauelement ausgeführt sein und eine Stabilität gegenüber vom späteren Benutzer ungewollte Verbiegungen und/oder Verformungen bieten.

Das zweite Substrat kann unabhängig von den Verfahrensschritten zur Herstellung der funktionellen Schichtenstapel hinsichtlich seiner Form und mechanischen Eigenschaften wie etwa Flexibilität gewählt werden. Beispielsweise kann das zweite Substrat eine ebene oder eine gekrümmte und gebogene Hauptoberfläche aufweisen, auf der der funktionelle Schichtenstapel im Verfahrensschritt C aufgebracht wird, und starr oder flexibel sein.

Weiterhin kann das zweite Substrat oberflächenmodifiziert sein und mit einer lichtstreuenden und/oder lichtlenkenden Oberfläche bereitgestellt werden. Die lichtstreunede und/oder lichtbrechende Oberfläche kann dabei eines oder mehrere Merkmale aufweisen wie weiter oben im Zusammenhang mit lichtstreuenden und/oder lichtbrechenden Eigenschaften des ersten Substrats beschrieben ist. Beispielsweise kann das zweite Substrat eine dem ersten Substrat abgewandte Oberfläche aufweisen, die eine wie oben beschriebene Oberflächenstruktur aufweist.

Der zumindest eine der Mehrzahl im Verfahrensschritt A herstellbaren funktionellen Schichtenstapel kann im Verfahrensschritt C unter Ausbildung einer mechanisch festen, also formschlüssigen und/oder stoffschlüssigen, Verbindung mittels einem oder mehreren oder einer Kombination von mehreren der folgenden Verfahren aufgebracht werden: thermisches Aufschmelzen ("melting""), etwa mittels eines Heizelements, optisches Aufschmelzen, etwa mittels eines Lasers ("laser joining"), Kleben, Laminieren, Bonden und mechanisches Befestigen, etwa Klemmen.

Zum Kleben und/oder Laminieren kann beispielsweise zwischen dem zweiten Substrat und dem funktionellen Schichtenstapel eine Verbindungsschicht in Form einer elektrisch isolierenden oder elektrisch leitenden Klebeschicht unstrukturiert und großflächig oder in Teilbereiche strukturiert aufgebracht werden. Die Klebeschicht kann damit die gesamte dem zweiten Substrat zugewandte Oberfläche des ersten Substrats bedecken oder nur Teile davon. Weiterhin kann auch alternativ oder zusätzlich zur Klebeschicht eine Verbindungsschicht zwischen dem zweiten Substrat und dem funktionellen Schichtenstapel großflächig oder strukturiert aufgebracht werden, die eine Wärmeleitpaste, ein optisches Gel wie etwa ein brechungsindexanpassendes Gel, einen brechungsindexanpassenden Klebstoff oder eine Kombination daraus umfasst. Die Verbindungsschicht kann somit auch die Klebeschicht umfassen und auch einen elektrisch isolierenden oder elektrisch leitenden Klebstoff aufweisen.

Im Verfahrensschritt B kann das zweite Substrat mit zumindest einem elektrischen Kontaktelement bereitgestellt werden, das eine elektrische Kontaktierung des zumindest einen funktionellen Schichtenstapels an das zweite Substrat ermöglicht. Das elektrische Kontaktelement kann beispielsweise eine Leiterbahn, eine elektrisch leitende Kontaktfläche und/oder aktive oder passive elektronische Komponenten aufweisen. Das elektrische Kontaktelement kann beispielsweise nach dem Verfahrensschritt C in elektrischem Kontakt zu einer unteren oder oberen Elektrodenschicht stehen. Darüber hinaus kann das elektrische Kontaktelement vor dem Verfahrensschritt C teilweise auf dem ersten Substrat und teilweise auf dem zweiten Substrat bereitgestellt sein, so dass das elektrische Kontaktelement durch den Verfahrensschritt C gebildet und vervollständigt wird.

Weiterhin kann das zweite Substrat mit zumindest einem elektrischen Anschluss zur elektrischen Kontaktierung des organischen elektronischen Bauelements bereitgestellt werden. Der elektrische Anschluss kann beispielsweise eine Leiterbahn, eine Bondpad oder eine elektrische Kontaktfläche aufweisen.

Insbesondere kann des zweite Substrat mit einer Mehrzahl von elektrischen Kontaktelementen und einer Mehrzahl von elektrischen Anschlüssen bereitgestellt werden, die jeweils zur elektrischen Kontaktierung einer unteren Elektrodenschicht und einer oberen Elektrodenschicht eines funktionellen Schichtenstapels auf dem zweiten Substrat vorgesehen sind.

Durch den elektrischen Anschluss oder eine Mehrzahl elektrischer Anschlüsse kann eine elektrische Kontaktierungsmöglichkeit des organischen elektronischen Bauelements auf dem zweiten Substrat für einen Benutzer bereitgestellt werden, so dass dieser den funktionellen Schichtenstapel auf dem zweiten Substrat auf einfache Weise elektrisch anschließen kann, ohne selbst für Anschlusspunkte auf dem funktionellen Schichtenstapel Sorge tragen zu müssen.

Das elektrische Kontaktelement und/oder der elektrische Anschluss können beispielsweise durch Aufdampfen von Metall, Aufbringen einer elektrisch leitenden Paste und/oder Aufbringen eines Drahtanschlusses ("wire bonding") bereitgestellt werden. Weiterhin kann das elektrische Kontaktelement und/oder der elektrische Anschluss zumindest teilweise durch Aufbringen eines wie oben beschriebenen elektrisch leitenden Klebstoffs oder einer Verbindungsschicht bereitgestellt werden.

In einem weiteren Verfahrensschritt D kann nach dem Verfahrensschritt C eine Verkapselung auf dem zweiten Substrat über dem zumindest einen funktionellen Schichtenstapel aufgebracht werden, wobei die Verkapselung das erste Substrat und damit den funktionellen Schichtenstapel gänzlich bedeckt. Das kann bedeuten, dass die Verkapselung eine Verbindungsfläche mit dem zweiten Substrat aufweist und die Verbindungsfläche das erste Substrat und damit den funktionellen Schichtenstapel gänzlich umläuft und umgibt. Die Verkapselung kann beispielsweise einen Glasdeckel und/oder eine Dünnschichtenfolge mit hochdichten aufgedampften Oxid- und/oder Nitridschichten aufweisen.

Das hier beschriebene Verfahren bietet somit die Möglichkeit, ohne Rücksicht auf mögliche Barriereeigenschaften des flexiblen ersten Substrats hinsichtlich Sauerstoff und Feuchtigkeit dieses für einen Bandbeschichtungsprozess optimal zu wählen. Durch das großflächige Aufbringen der zumindest einen organischen Schicht kann ein maskenfreier Prozess ermöglicht werden, der eine technisch einfache Aufbringanlage ermöglicht. Weiterhin sind in dem hier beschriebenen Verfahren die Verfahrensschritte des Aufbringens der zumindest einen organischen Schicht und gegebenenfalls der weiteren Schichten wie etwa Elektrodenschicht unabhängig von der Form des organischen elektronischen Bauelements und damit unabhängig vom nachfolgenden Vereinzelungsschritt. Dadurch kann zumindest nahezu die gesamte durch das erste Substrat zu Verfügung gestellt Fläche für das Aufbringen der zumindest einen organischen Schicht genutzt werden, wodurch der Ertrag des hier beschriebenen Verfahrens maximiert werden kann. Nach dem Vereinzeln kann jeder funktionelle Schichtenstapel vorab auf seine Funktionsfähigkeit getestet werden, so dass die Wahrscheinlichkeit eines späteren möglichen Ausfalls des organischen elektronischen Bauelements deutlich vermindert werden kann. Während in bekannten Herstellungsprozessen die Form eines organischen elektronischen Bauelements vorab gewählt werden muss, die Form des zur Verfügung gestellten einzelnen Substrats vorbestimmt ist und mittels eines In-Line-Prozesses durch ein strukturiertes Aufbringen von funktionalen Schichten verwirklicht werden muss, ist das hier beschriebene Verfahren aufgrund der vorab genannten Merkmale und Vorteile weniger kostenintensiv, flexibler und schneller als bekannte Herstellungsverfahren.

Weitere Vorteile und vorteilhafte Ausführungsformen und Weiterbildungen der Erfindung ergeben sich aus den im Folgenden in Verbindung mit den Figuren 1A bis 7I beschriebenen Ausführungsformen.

Es zeigen:
- Figuren 1A bis 1E: schematische Darstellungen eines Verfahrens zur Herstellung einer organischen elektronischen Bauelements gemäß einem Ausführungsbeispiel,
- Figur 2: eine schematische Darstellung eines Verfahrensschritts gemäß einem weiteren Ausführungsbeispiel,
- Figuren 3 bis 6: schematische Darstellungen von organischen elektronischen Bauelementen gemäß weiteren Ausführungsbeispielen und
- Figuren 7A bis 7I: schematische Darstellungen eines Verfahrens zur Herstellung einer organischen elektronischen Bauelements gemäß einem weiteren Ausführungsbeispiel.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben dick oder groß dimensioniert dargestellt sein.

In Folgenden werden Verfahren und organische elektronische Bauelemente am Beispiel von Ausführungsbeispielen für Verfahren zur Herstellung von organischen lichtemittierenden Dioden (OLEDs) und am Beispiel von Ausführungsbeispielen für OLEDs gezeigt.

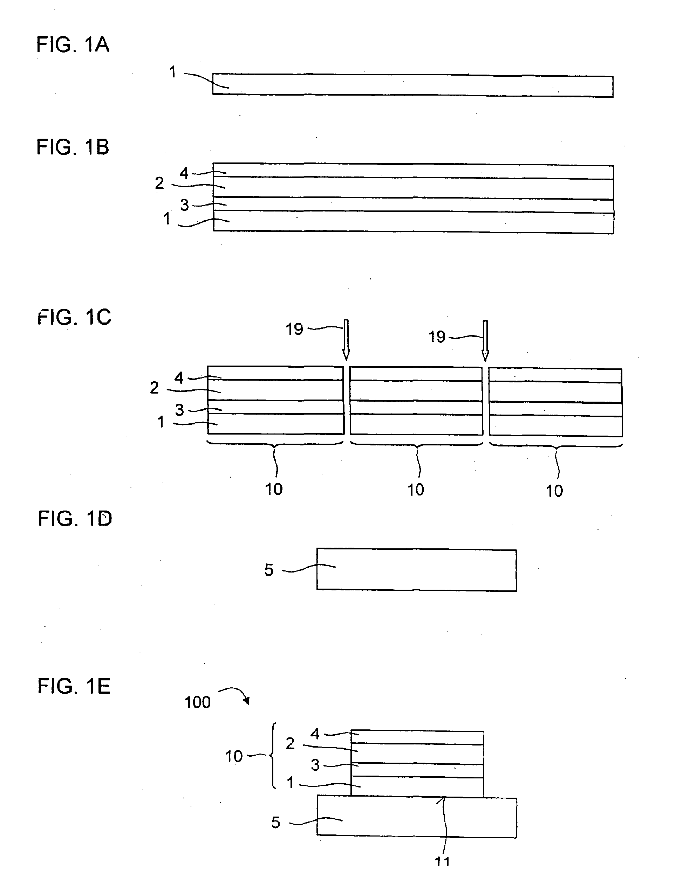

In den Figuren 1A bis 1E ist ein Ausführungsbeispiel für ein Verfahren zur Herstellung eines organischen elektronischen Bauelements 100 gezeigt.

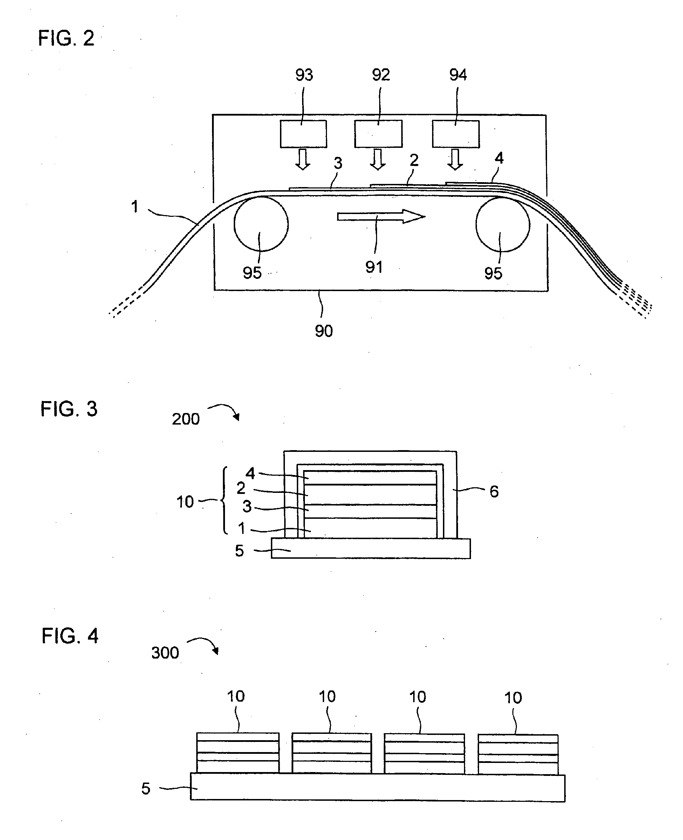

In einem ersten Verfahrensschritt A wird ein funktioneller Schichtenstapel 10 hergestellt. Dazu wird in einem Teilschritt A1 des Verfahrensschritts A gemäß Figur 1A ein flexibles erstes Substrat 1 bereitgestellt. Das erste Substrat 1 wird als transparente, flexible Folie aus einem Kunststoff bereitgestellt. Das erste Substrat 1, das im gezeigten Ausführungsbeispiel aus Polyethylen ist, wird dabei in Form einer Folienrolle bereitgestellt, die in einer Bandbeschichtungsanlage 90 gemäß Figur 2 weiterverarbeitet werden kann.

In einem weiteren Teilschritt A2 des Verfahrensschritts A wird gemäß Figur 1B zumindest eine organische Schicht 2 auf dem ersten Substrat 1 mittels der Bandbeschichtungsanlage 90 aufgebracht. Im gezeigten Ausführungsbeispiel wird gemäß Figur 1B weiterhin vor dem Aufbringen der zumindest einen organischen Schicht 2 eine untere Elektrödenschicht 3 auf dem ersten Substrat 1 aufgebracht. Über der zumindest einen organischen Schicht 2 wird eine obere Elektrodenschicht 4 aufgebracht. Im gezeigten Ausführungsbeispiel werden als untere Elektrodenschicht 3 eine Schicht aus Indiumzinnoxid (ITO) und als obere Elektrodenschicht 4 eine Aluminiumschicht aufgebracht. Die zumindest eine organische Schicht 2 umfasst eine organische Schichtenfolge mit einer Lochtransportschicht, einer Elektronentransportschicht und einem aktiven, elektrolumineszierenden Bereich, in dem im Betrieb des organischen elektronischen Bauelements 100 durch Rekombination von Löchern und Elektronen elektromagnetische Strahlung erzeugt werden kann. Weitere Einzelheiten zum Teilschritt A2 und insbesondere zur Bandbeschichtungsanlage 90 werden weiter unten im Zusammenhang mit Figur 2 erläutert.

In einem weiteren Teilschritt A3 des Verfahrensschritts A wird gemäß Figur 1C das erste Substrat 1 mit der zumindest einen organischen Schicht 2 in eine Mehrzahl von funktionellen Schichtenstapeln 10 vereinzelt, wie durch die Pfeile 19 angedeutet ist. Im gezeigten Ausführungsbeispiel erfolgt das Vereinzeln 19 durch mechanisches Schneiden, wobei die Formen der funktionellen Schichtenstapel 10 dabei individuell gewählt werden können und beispielsweise unterschiedlich voneinander sein können. Alternativ kann das Vereinzeln 19 auch mittels eines anderen, im allgemeinen Teil beschriebenen Trennverfahrens durchgeführt werden. Insbesondere für komplexe Formen der funktionellen Schichtenstapel 10 kann beispielsweise auch ein Lasertrennverfahren oder ein Trennverfahren mit Hilfe eines heißen Drahtes ("hot wire cutting") vorteilhaft sein.

Jeder der Mehrzahl der funktionellen Schichtenstapel 10 kann beispielsweise eine vorbestimmte geometrische Form aufweisen, über die im organischen elektronischen Bauelement 100 dekorative und/oder informative Eindrücke und Effekte hervorgerufen werden können. So können die funktionellen Schichtenstapel 10 beispielsweise auch in Form von informationsvermittelnden Piktogrammen, Zeichen, Buchstaben und/oder Zahlen vereinzelt werden.

In einem weiteren Verfahrensschritt B gemäß der Figur 1D wird ein zweites Substrat 5 bereitgestellt, das eine geringere Flexibilität als das erste Substrat 1 aufweist sowie eine höhere Dichtigkeit gegenüber Feuchtigkeit und Sauerstoff. Das zweite Substrat 5 ist im gezeigten Ausführungsbeispiel aus transparentem Glas und weist eine derartige Dicke auf, dass das zweite Substrat 5 hermetisch dicht gegenüber Feuchtigkeit und Sauerstoff ist.

In einem weitere Verfahrensschritt C gemäß Figur 1E wird einer der Mehrzahl der funktionellen Schichtenstapel 10 aus dem Verfahrensschritt A3 gemäß Figur 1C mit der der zumindest einen organischen Schicht 2 abgewandten Oberfläche 11 des Substrats 1 auf dem zweiten Substrat 5 aufgebracht, wodurch das organische elektronische Bauelement 100 gebildet wird. Dabei wird der funktionelle Schichtenstapel 10 auf dem zweiten Substrat 5 mittels einer Klebeschicht (nicht gezeigt) auflaminiert. Beispielsweise kann auch das erste Substrat 1 als selbstklebende Folie mit einer Klebeschicht auf der Oberfläche 11 bereits im Verfahrensschritt A1 bereitgestellt werden.

Das organische elektronische Bauelement 100 ist durch das transparente erste Substrat 1, die untere Elektrodenschicht 3 aus ITO und das transparente zweite Substrat 5 als so genannte Bottom-Emitter-OLED ausgebildet, also als OLED, die durch das zweite Substrat 5 hindurch in der zumindest einen organischen Schicht 2 erzeugte elektromagnetische Strahlung abstrahlen kann.

In Figur 2 ist ein Ausführungsbeispiel für den Verfahrensschritt A2 gemäß dem vorhergehenden Ausführungsbeispiel gezeigt. Dazu wird eine Bandbeschichtungsanlage 90 bereitgestellt, die in Figur 2 rein schematisch angedeutet ist.

Das erste Substrat 1, das wie oben beschrieben als Kunststofffolie auf einer Rolle (nicht gezeigt) bereitgestellt wird, wird über einen Transportmechanismus 95 durch die Bandbeschichtungsanlage 90 entlang einer Verarbeitungsrichtung 91 transportiert und beschichtet. Das beschichtete erste Substrat 1 mit der zumindest einen organischen Schicht 2 und der unteren und oberen Elektrodenschichten 3, 4 gemäß dem gezeigten Ausführungsbeispiel kann nach dem Aufbringen der Schichten wiederum auf eine Rolle (nicht gezeigt) aufgerollt werden und in dieser Form für die weiteren Verfahrensschritte bereitgestellt werden. Die Rollen zur Zuführung des ersten Substrat 1 und zur Aufnahme des beschichteten ersten Substrats 1 sowie die Bandbeschichtungsanlage 90 sind dabei in einem Vakuum oder in einer Schutzgasatmosphäre angeordnet, um eine Degeneration der zumindest einen organischen Schicht 2 und der unteren und der oberen Elektrodenschichten 3, 4 durch Sauerstoff und Feuchtigkeit zu vermeiden.

In der Bandbeschichtungsanlage 90 sind nacheinander Beschichtungselemente 93, 92 und 94 angeordnet, die im gezeigten Ausführungsbeispiel mittels thermischen Verdampfens die untere Elektrodenschicht 3, darüber die zumindest eine organische Schicht 2 in Form der oben beschriebenen Schichtenfolge und darüber die obere Elektrodenschicht 4 auf dem ersten Substrat 1 aufbringen. Das Aufbringen der unteren Elektrodenschicht 3, der zumindest einen organischen Schicht 2 und der oberen Elektrodenschicht 4 erfolgt dabei fortlaufend und kontinuierlich, so dass eine hohe Produktionsrate und damit eine hohe Wirtschaftlichkeit erreicht werden kann. Alternativ zum thermischen Verdampfen kann die untere Elektrodenschicht 3 beispielsweise auch durch Sputtern aufgebracht werden. Die zumindest eine organische Schicht kann auch beispielsweise mittels eines nasschemischen Verfahrens aufgebracht werden.

In Figur 3 ist ein weiteres Ausführungsbeispiel für ein organisches elektronisches Bauelement 200 gezeigt, das mittels eines Verfahrens gemäß der Figuren 1A bis 1E herstellbar ist und bei dem in einem weiteren Verfahrensschritt D eine Verkapselung 6 über dem funktionellen Schichtenstapel 10 aufgebracht wird.

Die Verkapselung 6 weist im gezeigten Ausführungsbeispiel einen Glasdeckel auf, der auf dem zweiten Substrat 5 aufgebracht wird. Der Glasdeckel wird dabei mittels einer Klebeschicht (nicht gezeigt) auf dem zweiten Substrat 5 befestigt und weist mit dem zweiten Substrat 5 eine Grenzfläche auf, die umlaufend um den funktionellen Schichtenstapel 10 angeordnet ist. Durch das hermetisch dichte zweite Substrat 5 und die Verkapselung 6 kann ein effektiver und hermetisch dichter Schutz des funktionellen Schichtenstapels 10 unabhängig von den Dichtigkeitseigenschaften des ersten Substrats 1 erreicht werden.

Alternativ oder zusätzlich zu dem Glasdeckel kann die Verkapselung 6 auch eine Dünnfilmverkapselung wie im allgemeinen Teil beschrieben aufweisen.

In Figur 4 ist ein weiteres Ausführungsbeispiel für ein organisches elektronisches Bauelement 300 gezeigt, bei dem im Verfahrensschritt C eine Mehrzahl von funktionellen Schichtenstapeln 10 nebeneinander auf dem zweiten Substrat 5 aufgebracht werden. Alternativ dazu oder zusätzlich können funktionelle Schichtenstapel 10 auch übereinander aufgebracht werden. Die einzelnen funktionellen Schichtenstapel 10 können dabei beispielsweise jeweils eine unterschiedliche Form aufweisen und im fertiggestellten organischen elektronischen Bauelement 300 unabhängig voneinander in Betrieb genommen werden. Weiterhin können die funktionellen Schichtenstapel 10 in verschiedenen Verfahrensschritten A hergestellt werden und etwa unterschiedliche Materialien aufweisen.

Durch die Mehrzahl von funktionellen Schichtenstapeln 10 kann das als OLED ausgeführte organische elektronische Bauelement 300 beispielsweise in verschiedenen Betriebszuständen unterschiedliche Farbeindrücke erwecken und/oder unterschiedliche Leuchtflächen aufweisen und dadurch einen veränderbaren Leuchteindruck und/oder eine veränderbare Informationswiedergabe ermöglichen.

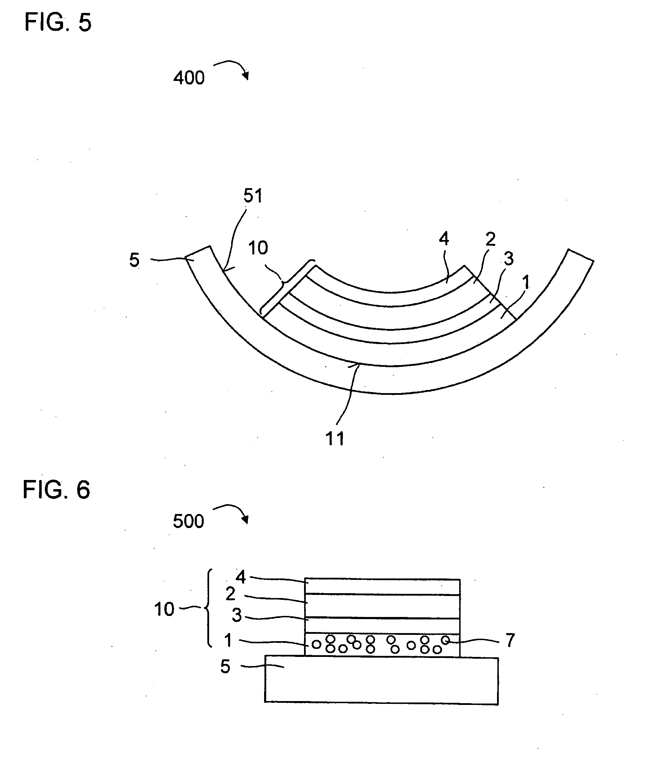

In Figur 5 ist ein weiteres Ausführungsbeispiel für ein organisches elektronisches Bauelement 400 gezeigt, das ein gebogenes zweites Substrat 5 aufweist. Der funktionelle Schichtenstapel 10 ist somit auf einer gebogenen und gekrümmten Hauptoberfläche des zweiten Substrats 5 angeordnet. Aufgrund der Tatsache, dass das erste Substrat 1 für einen Bandbeschichtungsprozess gemäß Verfahrensschritt A2 geeignet ist, kann die Form des funktionellen Schichtenstapels 10 auch an Oberflächen mit großer Krümmung angepasst werden.

Alternativ oder zusätzlich kann das zweite Substrat 5 flexibel sein, wobei der funktionelle Schichtenstapel 10 durch die höhere Flexibilität des ersten Substrats 1 im Vergleich zum zweiten Substrat 5 durch Krümmungsänderungen des zweiten Substrats 5 in seiner Funktionalität nicht beeinträchtigt wird.

In Figur 6 ist ein weiteres Ausführungsbeispiel für ein organisches elektronisches Bauelement 500 gezeigt, das ein erstes Substrat 1 mit Streupartikeln 7 aufweist. Das erste Substrat 1 wird dabei als Folie mit einem Kunststoff als Matrixmaterial bereitgestellt, in das die Streupartikel, beispielsweise Glaspartikel, eingebettet sind. Das erste Substrat 1 kann im Betrieb des als OLED ausgeführten organischen elektronischen Bauelements 500 die Lichteinkopplung vom ersten Substrat 1 in das zweite Substrat 5 erhöhen.

Alternativ oder zusätzlich zu den vorab beschriebenen Merkmalen des ersten Substrats 1 im gezeigten Ausführungsbeispiel kann das erste Substrat 1 auch weitere lichtstreuende oder lichtlenkende Merkmale wie im allgemeinen Teil beschrieben aufweisen. Alternativ oder zusätzlich zu den Streupartikeln 7 kann das erste Substrat 1 beispielsweise auch einen Wellenlängenkonversionsstoff aufweisen.

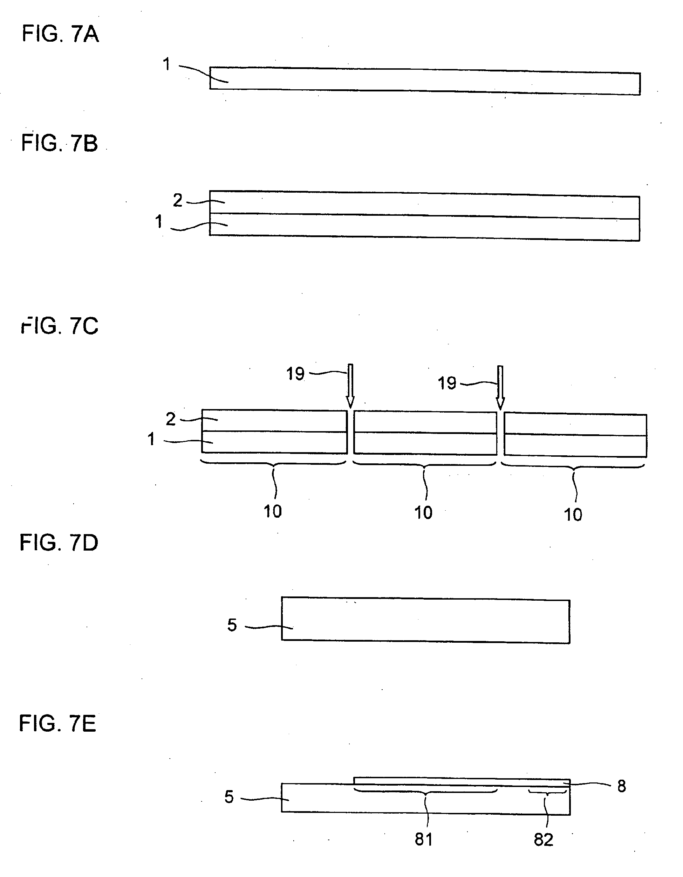

In den Figuren 7A bis 7I ist ein weiteres Ausführungsbeispiel für ein Verfahren zur Herstellung eines organischen elektronischen Bauelements 600 gezeigt.

In einem ersten Verfahrensschritt A gemäß der Figuren 7A bis 7C wird eine Mehrzahl von funktionellen Schichtenstapeln 10 hergestellt. Dazu wird in einem ersten Teilschritt A1 des Verfahrensschritts A ein flexibles erstes Substrat 1 bereitgestellt, das als Metallfolie ausgebildet ist. Das erste Substrat 1 wird dabei in Form einer für einen Bandbeschichtungsprozess geeigneten Edelstahlfolie bereitgestellt, die später im organischen elektronischen Bauelement 600 gleichzeitig als untere Elektrodenschicht wirken kann. Alternativ dazu kann beispielsweise auch ein Laminat mit einer Kunststofffolie und einer Metallfolie oder eine metallbeschichtete Kunststofffolie als erstes Substrat bereitgestellt werden

In einem zweiten Teilschritt A2 des Verfahrensschritts A wird gemäß Figur 7B mittels einer Bandbeschichtungsanlage eine erste organische Schicht 2 auf dem ersten Substrat 1 großflächig und zusammenhängend aufgebracht. Die Bandbeschichtungsanlage kann dabei Merkmale wie in Verbindung mit Figur 2 und wie im allgemeinen Teil beschrieben aufweisen. Die zumindest eine organische Schicht 2 umfasst eine organische Schichtenfolge mit zumindest einer Lochtransportschicht, zumindest einer elektrolumineszierenden Schicht und zumindest einer Elektronentransportschicht, die in einem nasschemischen Verfahren aufgebracht werden.

In einem weiteren Teilschritt A3 des Verfahrensschritt A gemäß Figur 7C wird das mit der zumindest einen organischen Schicht 2 beschichtete erste Substrat 1 in funktionelle Schichtenstapel 10 vereinzelt, wie durch die Pfeile 19 angedeutet ist. Das Vereinzeln 19 erfolgt im vorliegenden Ausführungsbeispiel durch Stanzen.

In einem weiteren Verfahrensschritt B gemäß der Figuren 7D und 7E wird ein zweites Substrat 5 aus Glas mit einer Leiterbahn 8 bereitgestellt. Dazu wird in einem ersten Teilschritt gemäß Figur 7D das zweite Substrat 5 bereitgestellt. In einem zweiten Teilschritt gemäß Figur 7E wird eine Leiterbahn 8 auf einer Hauptoberfläche des zweiten Substrats 5 durch Aufdampfen eines Metalls aufgebracht.

Die Leiterbahn 8 weist ein elektrisches Kontaktelement 81 zur späteren elektrischen Kontaktierung einer der im Verfahrensschritt A hergestellten funktionellen Schichtenstapeln 10 auf. Das elektrische Kontaktelement 81 ist dabei gleichzeitig als Montagefläche für einen funktionellen Schichtenstapel 10 ausgebildet.

Die Leiterbahn 8 weist weiterhin einen elektrischen Anschluss 82 auf, der neben dem durch das elektrische Kontaktelement 81 gebildeten Montagebereich angeordnet ist. Das organische elektronische Bauelement 600 kann zur späteren Inbetriebnahme von einem Benutzer über den elektrischen Anschluss 82 beispielsweise durch Bonden oder durch Anschluss eines geeigneten Steckverbinders elektrisch kontaktiert werden, ohne dass der Benutzer den funktionellen Schichtenstapel 10 selbst direkt kontaktieren muss.

Zusätzlich zur gezeigten Leiterbahn 8 können auf dem zweiten Substrat 5 noch weitere Leiterbahnen, beispielsweise zur elektrischen Kontaktierung einer oberen Elektrodenschicht 4, aufgebracht werden. Weiterhin können zusätzlich zu den Leiterbahnen auch elektronische aktive und/oder passive Komponenten auf dem zweiten Substrat 5 aufgebracht werden.

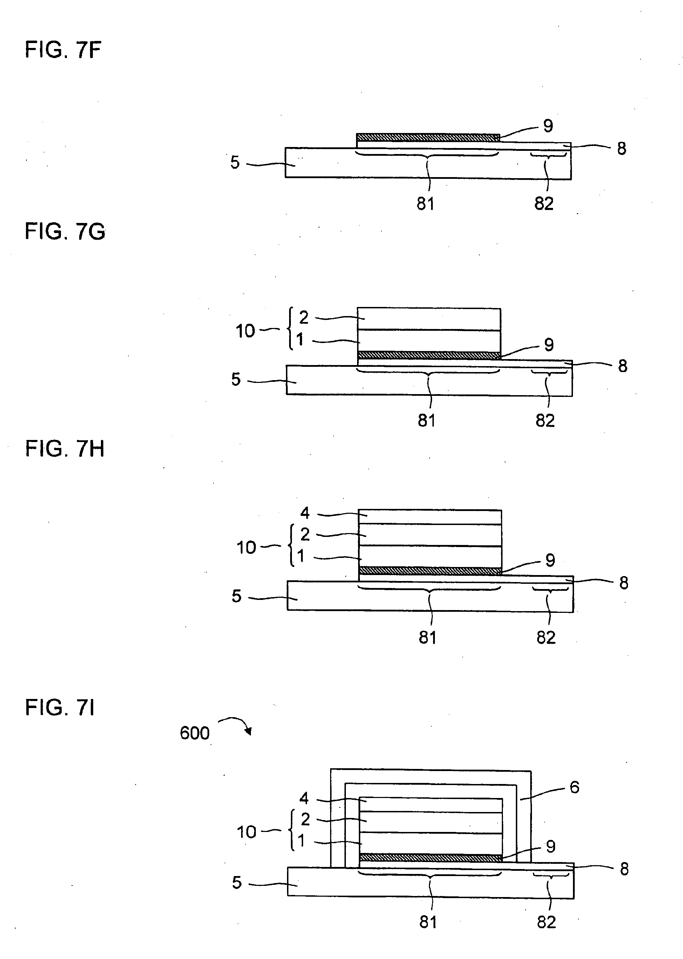

In einem weiteren Verfahrensschritt C gemäß der Figuren 7F bis 7H wird ein im Verfahrensschritt A hergestellter funktioneller Schichtenstapel 10 auf dem zweiten Substrat 5 aufgebracht. Dazu wird in einem Teilschritt des Verfahrensschritts C auf dem elektrischen Kontaktelement 81 der Leiterbahn 8 eine elektrische Verbindungsschicht 9 aufgebracht. Die elektrische Verbindungsschicht weist im gezeigten Ausführungsbeispiel einen elektrisch leitenden Klebstoff auf. Alternativ dazu kann die Verbindungsschicht beispielsweise auch ein niedrigschmelzendes Lot aufweisen. Gemäß Figur 7G wird in einem weiteren Teilschritt des Verfahrensschritts C ein im Verfahrensschritt A hergestellter funktioneller Schichtenstapel 10 auf die Verbindungsschicht 9 auf dem elektrischen Kontaktelement 91 der Leiterbahn 8 aufgebracht. Über die Leiterbahn 8, die Verbindungsschicht 9 und das als untere Elektrodenschicht wirkende erstes Substrat 1 kann so ein elektrischer Kontakt der zumindest einen organischen Schicht 2 mit dem elektrischen Anschluss 82 erfolgen.

In einem weiteren Verfahrensschritt gemäß Figur 7H wird auf der zumindest einen organischen Schicht 2 des funktionellen Schichtenstapels 10 eine transparente obere Elektrodenschicht 4 aufgebracht, die eine transparente Metallschicht aufweist. Alternativ oder zusätzlich dazu kann die obere Elektrodenschicht 4 auch eine oder mehrere TCO-Schichten umfassen. Die obere Elektrodenschicht 4 kann dabei auch derart aufgebracht werden, dass ein elektrischer Anschluss über eine weitere, nicht gezeigte Leiterbahn bereitgestellt werden kann.

In einem weiteren Verfahrensschritt D gemäß Figur 7I wird über dem funktionellen Schichtenstapel 10 eine transparente Verkapselung 6 in Form einer mehrschichtigen Dünnschichtverkapselung aufgebracht, die den funktionellen Schichtenstapel 10 gänzlich überdeckt und zusammen mit dem zweiten Substrat 5 eine hermetisch dichte Verkapselung für den funktionellen Schichtenstapel 10 bildet.

Das derart hergestellte organische elektronische Bauelement 600 kann im Betrieb in der zumindest einen organischen Schicht 2 im Betrieb Licht erzeugen, das durch die transparente obere Elektrodenschicht 4 und die Verkapselung 6 in eine vom zweiten Substrat 5 abgewandte Richtung abgestrahlt werden kann, so dass das organische elektronische Bauelement im gezeigten Ausführungsbeispiel als Top-Emitter-OLED ausgebildet ist.

## Patentansprüche

1. Verfahren zur Herstellung eines organischen elektronischen Bauelements mit den Schritten:
A) Herstellen zumindest eines funktionellen Schichtenstapels (10) mit den Teilschritten:
A1) Bereitstellen eines flexiblen ersten Substrats (1), A2) Großflächiges Aufbringen zumindest einer organischen Schicht (2) auf dem ersten Substrat (1) mittels einer Bandbeschichtungsanlage (90) und
A3) Vereinzeln des ersten Substrats (1) mit der zumindest einen organischen Schicht (2) in eine Mehrzahl funktioneller Schichtenstapel (10),
B) Bereitstellen eines zweiten Substrats (5), das eine geringere Flexibilität und eine höhere Dichtigkeit gegenüber Feuchtigkeit und Sauerstoff als das erste Substrat (1) aufweist, und
C) Aufbringen des zumindest einen der Mehrzahl der funktionellen Schichtenstapel (10) mit einer der organischen Schicht (2) abgewandten Oberfläche (11) des ersten Substrats (1) auf dem zweiten Substrat (5).

2. Verfahren nach Anspruch 1, bei dem
- das erste Substrat (1) eine Folie aus einem Kunststoff und/oder einem Metall aufweist.

3. Verfahren nach einem der vorherigen Ansprüche, bei dem
- das erste Substrat (1) durchlässig für Feuchtigkeit und Sauerstoff ist.

4. Verfahren nach einem der vorherigen Ansprüche, bei dem
- die zumindest eine organische Schicht (2) zusammenhängend und großflächig auf dem ersten Substrat (1) aufgebracht wird.

5. Verfahren nach einem der vorherigen Ansprüche, bei dem
- im Verfahrensschritt A3 das erste Substrat (1) mittels eines mechanischen, optischen oder thermischen Trennverfahrens (19) oder einer Kombination daraus vereinzelt wird.

6. Verfahren nach einem der vorherigen Ansprüche, bei dem
- vor dem Vereinzeln in Verfahrensschritt A3 eine obere Elektrodenschicht (4) auf der zumindest einen organischen Schicht (2) aufgebracht wird.

7. Verfahren nach einem der vorherigen Ansprüche, bei dem
- nach dem Vereinzeln (19) in Verfahrensschritt A3 eine obere Elektrodenschicht (4) auf der zumindest einen organischen Schicht (2) aufgebracht wird.

8. Verfahren nach einem der vorherigen Ansprüche, bei dem
- das zweite Substrat (5) hermetisch dicht gegenüber Sauerstoff und/oder Feuchtigkeit ist.

9. Verfahren nach einem der vorherigen Ansprüche, bei dem
- im Verfahrensschritt B das zweite Substrat (5) mit zumindest einem elektrischen Kontaktelement (81) zur elektrischen Kontaktierung des zumindest einen funktionellen Schichtenstapels (10) an das zweite Substrat (5) bereitgestellt wird.

10. Verfahren nach einem der vorherigen Ansprüche, bei dem
- in Verfahrensschritt C der zumindest eine funktionelle Schichtenstapel (10) mittels einer Verbindungsschicht (9) umfassend eine Wärmeleitpaste, einen brechungsindexangepassten Klebstoff, ein brechungsindexangepasstes Gel, einen elektrisch leitenden Klebstoff oder einer Kombination daraus auf dem zweiten Substrat (5) aufgebracht wird.

11. Verfahren nach einem der vorherigen Ansprüche mit dem zusätzlichen Schritt
D) Aufbringen einer Verkapselung (6) auf dem zweiten Substrat (5) über dem zumindest einen funktionellen Schichtenstapel (10), wobei die Verkapselung (6) den funktionellen Schichtenstapel (10) gänzlich bedeckt.

## Claims

1. Method for producing an organic electronic component comprising the following steps:
A) producing at least one functional layer stack (10) with the following substeps:
A1) providing a flexible first substrate (1), A2) applying at least one organic layer (2) in large-area fashion on the first substrate (1) by means of a coil coating plant (90), and
A3) singulating the first substrate (1) with the at least one organic layer (2) into a plurality of functional layer stacks (10),
B) providing a second substrate (5), which has a lower flexibility and a higher impermeability with respect to moisture and oxygen than the first substrate (1), and
C) applying the at least one of the plurality of the functional layer stacks (10) with a surface (11) of the first substrate (1) remote from the organic layer (2) on the second substrate (5).

2. Method according to Claim 1, wherein
- the first substrate (1) comprises a film composed of a plastic and/or a metal.

3. Method according to either of the preceding claims, wherein:
- the first substrate (1) is permeable to moisture and oxygen.

4. Method according to any of the preceding claims, wherein
- the at least one organic layer (2) is applied continuously and in large-area fashion on the first substrate (1).

5. Method according to any of the preceding claims, wherein
- in method step A3 the first substrate (1) is singulated by means of a mechanical, optical or thermal separation method (19) or a combination thereof.

6. Method according to any of the preceding claims, wherein
- before the singulation in method step A3 a top electrode layer (4) is applied on the at least one organic layer (2).

7. Method according to any of the preceding claims, wherein
- after the singulation (19) in method step A3 a top electrode layer (4) is applied on the at least one organic layer (2).

8. Method according to any of the preceding claims, wherein
- the second substrate (5) is hermetically impermeable with respect to oxygen and/or moisture.

9. Method according to any of the preceding claims, wherein
- method step B involves providing the second substrate (5) with at least one electrical contact element (81) for electrically contact-connecting the at least one functional layer stack (10) to the second substrate (5).

10. Method according to any of the preceding claims, wherein
- method step C involves applying the at least one functional layer stack (10) by means of a connecting layer (9) comprising a thermally conductive paste, a refractive-index-matched adhesive, a refractive-index-matched gel, an electrically conductive adhesive or a combination thereof on the second substrate (5).

11. Method according to any of the preceding claims comprising the following additional step:
D) applying an encapsulation (6) on the second substrate (5) above the at least one functional layer stack (10), wherein the encapsulation (6) completely covers the functional layer stack (10).

## Revendications

1. Procédé de fabrication d'un composant électronique organique avec les étapes suivantes :
A) fabrication d'au moins une pile de couches fonctionnelles (10) avec les étapes partielles suivantes :
A1) mise à disposition d'un premier substrat (1) flexible ;
A2) application sur une grande surface d'au moins une couche organique (2) sur le premier substrat (1) au moyen d'une installation de revêtement de bandes (90) ; et
A3) séparation du premier substrat (1) avec l'au moins une couche organique (2) dans une pluralité de piles de couches fonctionnelles (10) ;
B) mise à disposition d'un deuxième substrat (5) présentant une flexibilité davantage réduite et une étanchéité supérieure par rapport au premier substrat (1) en terme d'humidité et d'oxygène ; et
C) application de l'au moins une pluralité de piles de couches fonctionnelles (10) sur le deuxième substrat (5) avec une surface (11), opposée à la couche organique (2), du premier substrat (1).

2. Procédé selon la revendication 1, dans lequel :
- le premier substrat (1) comporte un film composé d'une matière plastique et/ou d'un métal.

3. Procédé selon l'une quelconque des revendications précédentes, dans lequel :
- le premier substrat (1) est perméable à l'humidité et l'oxygène.

4. Procédé selon l'une quelconque des revendications précédentes, dans lequel :
- l'au moins une couche organique (2) est appliquée par accrochage conjoint et application sur une grande surface sur le premier substrat (1).

5. Procédé selon l'une quelconque des revendications précédentes, dans lequel :
- à l'étape de procédé A3, le premier substrat (1) est séparé à l'aide d'un procédé de séparation (19) mécanique, optique ou thermique ou d'une combinaison de ceux-ci.

6. Procédé selon l'une quelconque des revendications précédentes, dans lequel :
- avant la séparation à l'étape de procédé A3, une couche d'électrode (4) supérieure est appliquée sur l'au moins une couche organique (2).

7. Procédé selon l'une quelconque des revendications précédentes, dans lequel :
- après la séparation (19) à l'étape de procédé A3, une couche d'électrode (4) supérieure est appliquée sur l'au moins une couche organique (2).

8. Procédé selon l'une quelconque des revendications précédentes, dans lequel :
- le deuxième substrat (5) est hermétiquement étanche à l'oxygène et/ou l'humidité.

9. Procédé selon l'une quelconque des revendications précédentes, dans lequel :
- à l'étape de procédé B, le deuxième substrat (5) est mis à disposition avec au moins un élément de contact (81) électrique pour la mise en contact électrique de l'au moins une pile de couches fonctionnelles (10) au niveau du deuxième substrat (5).

10. Procédé selon l'une quelconque des revendications précédentes, dans lequel :
- à l'étape de procédé C, l'au moins une pile de couches fonctionnelles (10) est appliquée sur le deuxième substrat (5) au moyen d'une couche de liaison (9) comprenant une pâte thermoconductrice, une colle à indice de réfraction adapté, un gel à indice de réfraction adapté, une colle électriquement conductrice ou une combinaison de ceux-ci.

11. Procédé selon l'une quelconque des revendications précédentes avec l'étape supplémentaire suivante :
D) application d'un encapsulage (6) sur le deuxième substrat (5) via l'au moins une pile de couches fonctionnelles (10), l'encapsulage (6) recouvrant entièrement la pile de couches fonctionnelles (10).
